Europäisches Patentamt

European Patent Office

Office européen des brevets

(19)

(11) EP 0 806 083 B1

(12) EUROPÄISCHE PATENTSCHRIFT

(45) Veröffentlichungstag und Bekanntmachung des Hinweises auf die Patenterteilung:
07.10.1998 Patentblatt 1998/41

(51) Int Cl.6: **H03K 17/10**, H03K 17/693, G11C 16/06

(21) Anmeldenummer: 95942654.5

(22) Anmeldetag: 29.12.1995

(86) Internationale Anmeldenummer:
PCT/DE95/01875

(87) Internationale Veröffentlichungsnummer:
WO 96/23356 (01.08.1996 Gazette 1996/35)

(54) **MOS-SCHALTUNGSANORDNUNG ZUM SCHALTEN HOHER SPANNUNGEN AUF EINEM HALBLEITERCHIP**

MOS CIRCUIT FOR SWITCHING HIGH VOLTAGES ON A SEMICONDUCTOR CHIP

CIRCUIT MOS PERMETANT LA COMMUTATION DE TENSIONS ELEVEES SUR UNE PUCE DE SEMICONDUCTEUR

(84) Benannte Vertragsstaaten:
AT CH DE ES FR GB IT LI

(30) Priorität: 24.01.1995 DE 19502116

(43) Veröffentlichungstag der Anmeldung:
12.11.1997 Patentblatt 1997/46

(73) Patentinhaber: SIEMENS AKTIENGESELLSCHAFT
80333 München (DE)

(72) Erfinder:
• HANNEBERG, Armin
D-85540 Haar (DE)
• TEMPEL, Georg
D-81927 München (DE)

(56) Entgegenhaltungen:
EP-A- 0 456 623    US-A- 5 077 691
US-A- 5 335 200    US-A- 5 371 705

## Beschreibung

Bei der Realisierung elektronischer Schaltkreise als integrierte Schaltung auf einem Halbleiterchip ist es manchmal nötig, höhere Spannungen als die Versorgungsspannung und auch negative Spannungen auf dem Chip zu den Schaltkreisen oder Teilen davon zu schalten. Die hohen positiven oder negativen Spannungen können dabei entweder dem Chip zusätzlich zu den üblichen Versorgungsspannungen zugeführt oder mittels Ladungspumpen auf dem Chip aus den Versorgungsspannungen er; zeugt werden. In jedem Fall muß für ein sicheres und schnelles Schalten gesorgt werden, wobei der Spannungsabfall am Schalter so gering wie möglich sein soll.

So ist es bei neuartigen Flash-Speichern und in Zukunft auch bei Standard-EEPROMs nötig, zur Selektion einer Wortleitung eine negative Wortleitungsspannung an diese zu legen. Nicht selektierte Wortleitungen werden in diesem Fall auf einem Potential von 0V gehalten.

Bei der EP 0 456 623 A2 wird mit einer gepulsten positiven Hochspannung über einen Kondensator in einer Spannungsinvertierschaltung das Gate eines p-MOS-Transfer-Transistors negativ gepolt, so daß die negative Spannung aus einer Ladungspumpe zur Wortleitung eines Speichers gelangt. Wegen Leckströmen in den Verbindungen muß diese Schaltung im Burst-Modus betrieben werden. Das heißt, es sind sich wiederholende Pulse bis zum Ende der Programmierung nötig, woraus sich eine höhere Verlustleistung ergibt.

Da die auch auf einem Speicherchip außer den Speicherzellen meist zusätzlich vorhandenen Logikschaltungen in MOS-Technik ausgeführt sind und solche Schaltungen damit standardmäßig mit rein positiven Spannungen betrieben werden, muß eine Isolation der negativen Spannung zum Substrat des Halbleiterchip gewährleistet sein. Dies kann zum Beispiel mittels isolierter Wannen, in sogenannter "triple-well"-Technik erreicht werden.

Bei einem p-Substrat ist dabei eine p-Wanne für n-Kanal-Transistoren in einer tiefen n-Wanne angeordnet und durch diese vom p-Substrat isoliert. Eine solche tiefe Wanne wird etwa durch eine Hochenergie-Implantation mit typischerweise 1 bis 3 MeV bei Phosphor als Dotierungsmaterial oder durch niedrigere Energie und eine extrem lange Diffusionszeit erhalten.

Die Aufgabe der Erfindung ist es, eine MOS-Schaltungsanordnung zum Schalten negativer und in Weiterbildung auch positiver hoher Spannungen mittels rein positiver Schaltpegel auf einem Halbleiterchip anzugeben, die keine isolierte(n) Wanne(n) benötigt.

Die Aufgabe wird durch Schaltungsanordnungen gemäß der Ansprüche 1 und 3 gelöst. Vorteilhafte Weiterbildungen sind in den Unteransprüchen angegeben.

Ein besonderer Vorteil der erfindungsgemäßen Schaltungsanordnung liegt darin, daß zu der technologischen Realisierung keine teuren Anlagen beziehungsweise keine längeren Ausheizzeiten für einen Diffusionsprozeßschritt nötig sind. Es sind auch keine weiteren Prozeßschritte nötig, da in CMOS-Technik die Transistoren vom selben Leitungstyp wie das Substrat bereits in einer Wanne realisiert sind und somit ein solcher Prozeßschritt bei Realisierung von CMOS-Technik bereits vorhanden ist.

Die erfindungsgemäße Schaltungsanordnung eignet sich besonders gut zum Schalten von negativen oder in deren Weiterbildung auch von positiven Programmier- beziehungsweise Löschspannungen auf die Wortleitungen eines Flash- oder auch EEPROM-Speichers, wobei jeweils nur eine Wortleitung selektiert werden kann.

Die Erfindung soll nachfolgend anhand von Ausführungsbeispielen mit Hilfe von Figuren näher erläutert werden. Dabei zeigen:

Figur 1  eine erste Variante einer erfindungsgemäßen Schaltungsanordnung,

Figur 2  eine zweite Variante einer erfindungsgemäßen Schaltungsanordnung und

Figur 3  eine Darstellung der an die erste Variante anzulegenden Spannungen, um eine gewünschte Ausgangsspannung zu erhalten.

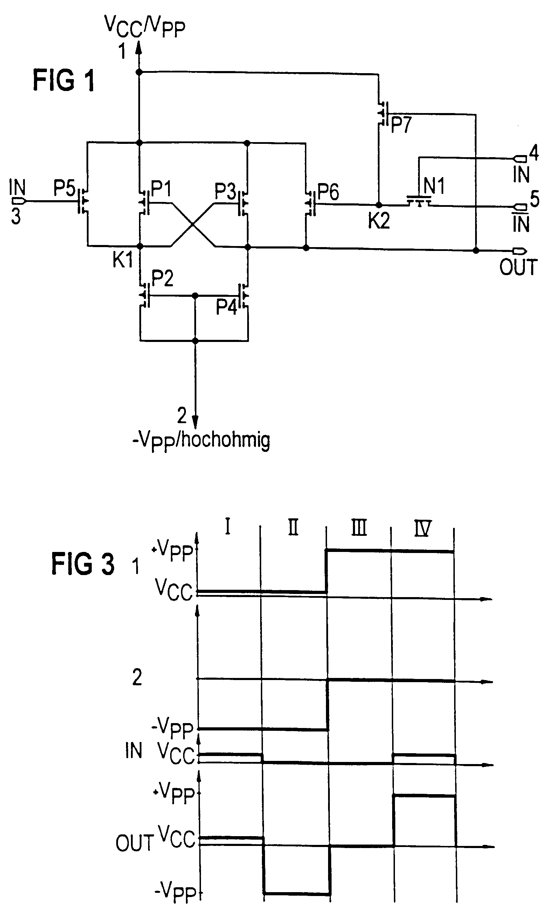

Die in Figur 1 gezeigte Schaltungsanordnung ermöglicht es, entweder eine an einen ersten Anschluß 1 angelegte hohe Spannung Vpp oder eine an einen zweiten Anschluß 2 angelegte hohe negative Spannung -Vpp abhängig von einem Eingangssignal IN, IN an Steueranschlüssen 3, 4, 5 auf einen Ausgangsanschluß OUT zu schalten. Das Beispiel bezieht sich auf eine Realisierung der Schaltungsanordnung als integrierte Schaltung in einem p-Substrat mit in n-Wannen ausgebildeten p-Kanal-Transistoren. In äquivalenter Weise könnten natürlich in einem n-Substrat n-Kanal-Transistoren realisiert werden. Zwischen dem ersten Anschluß 1 und dem zweiten Anschluß 2 ist eine erste Serienschaltung aus einem ersten Transistor P1 und einem zweiten Transistor P2 sowie parallel dazu eine zweite Serienschaltung aus einem dritten Transistor P3 und einem vierten Transistor P4 angeordnet. Die Gate-Anschlüsse des zweiten und vierten Transistors P2, P4 sind ebenfalls mit dem zweiten Anschluß 2 verbunden, so daß die beiden Transistoren P2, P4 als mit Dioden realisierte Stromquellen fungieren. Der Gate-Anschluß des dritten Transistors P3 ist mit dem Verbindungspunkt K1 des ersten und zweiten Transistors P1, P2 und der Gate-Anschluß des ersten Transistors P1 mit dem den Ausgangsanschluß OUT bildenden Verbindungspunkt des dritten Transistors P3 und vierten Transistors P4 verbunden. Die Transistoren Pl bis P4 sind dabei so dimensioniert, daß im Falle, daß der zweite und der vierte Transistor P2, P4 leitend geschaltet sind, zuerst der Verbindungspunkt K1 des ersten und zweiten Transistors P1, P2 zum zweiten Anschluß 2 gezogen wird, so daß der dritte Transistor P3 leitet und damit den Ausgangsanschluß OUT zum am ersten Anschluß 1 anliegenden positiven Potential zieht, so daß der erste Transistor P1 sperrt. Parallel zur Laststrecke des ersten Transistors P1 ist die Laststrecke eines fünften Transistors P5 geschaltet. Der Gate-Anschluß dieses fünften Transistors P5 ist mit dem Steueranschluß 3 verbunden.

Mit diesem Teil der in der Figur 1 dargestellten Schaltungsanordnung ist es bereits möglich, eine am Anschluß 2 angelegte hohe negative Spannung -Vpp an den Ausgangsanschluß OUT mittels eines am Steuereingang 3 angelegten Eingangssignals IN zu schalten, wenn am ersten Anschluß 1 die Halbleiterchip-Versorgungsspannung Vcc anliegt. Dies ist in Figur 3 in den mit I und II gekennzeichneten Zeitintervallen dargestellt. Solange am Steuereingang 3 der Zustand des Eingangssignals IN einem logischen High-Zustand entspricht, das heißt also bei CMOS-Schaltungen etwa dem Wert der positiven Versorgungsspannung Vcc entspricht, sperrt der fünfte Transistor P5. Da der zweite und der vierte Transistor P2, P4 leiten, wird aufgrund der geeigneten Dimensionierung der Transistoren P1 bis P4 der Verbindungspunkt K1 des ersten und zweiten Transistors zum Potential -Vpp am zweiten Anschluß 2 gezogen, so daß der dritte Transistor P3 leitet und damit den Ausgangsanschluß OUT zum Versorgungsspannungspotential Vcc, das am ersten Anschluß 1 anliegt, zieht, wodurch der erste Transistor P1 sperrt und die Schaltungsanordnung dadurch in diesem Zustand verriegelt ist. Dieser Zustand ist im Zeitabschnitt I der Figur 3 dargestellt. Wenn nun, wie in Zeitabschnitt II der Figur 3 gezeigt, der Zustand des Eingangssignals IN am Steuereingang 3 zu einem logischen Low-Zustand wechselt, das heißt also, einen Wert von 0V annimmt, so leitet der fünfte Transistor P5, wodurch der Verbindungspunkt K1 zum Versorgungsspannungspotential Vcc gezogen wird und dadurch der dritte Transistor P3 sperrt. Nun wird der Ausgangsanschluß OUT aufgrund des leitenden vierten Transistors P4 zum am zweiten Anschluß 2 anliegenden hohen negativen Potential -Vpp gezogen, wodurch der erste Transistor P1 ebenfalls leitet und dadurch die Schaltung wieder in diesem Zustand verriegelt wird.

Soll auch eine am ersten Anschluß 1 anliegende hohe positive Spannung Vpp zum Ausgangsanschluß OUT durchgeschaltet werden können, so muß die bisher beschriebene Schaltung gemäß der in Figur 1 dargestellten Schaltungsanordnung ergänzt werden. Hierzu ist der Laststrecke des dritten Transistors P3 die Laststrecke eines sechsten Transistors P6 parallel geschaltet. Zwischen dem ersten Anschluß 1 und dem Gate-Anschluß des sechsten Transistors P6 ist die Laststrecke eines siebten Transistors P7 geschaltet, dessen Gate-Anschluß mit dem Ausgangsanschluß OUT verbunden ist. Der Gate-Anschluß des sechsten Transistors P6 ist über die Laststrecke eines ersten n-Kanal-Transistors N1 mit einem Steuereingang 6 für ein invertiertes Eingangssignal $\overline{\text{IN}}$ verbunden, wobei der Gate-Anschluß des ersten n-Kanal-Transistors N1 mit einem Steueranschluß 4 für das Eingangssignal IN verbunden ist. Der Gate-Anschluß des ersten n-Kanal-Transistors N1 könnte natürlich genauso mit dem Steueranschluß 3 verbunden sein. Da der erste n-Kanal-Transistor N1 an keinem seiner Anschlüsse mit dem hohen negativen Potential -Vpp in Kontakt kommen kann, ist es nicht nötig, ihn in einer tiefen Wanne auszubilden. Um an den Ausgangsanschluß OUT eine hohe positive Spannung Vpp durchzuschalten, wird diese an den ersten Anschluß 1 statt der Versorgungsspannung Vcc gelegt. Der zweite Anschluß 2 wird in einem schwebenden Zustand gehalten, was entweder durch Abschalten der Quelle für das hohe negative Potential -Vpp geschehen kann oder dadurch, daß der Ausgang dieser Quelle einen hochohmigen Zustand einnimmt.

Solange das Eingangssignal IN weiterhin einen logischen Low-Zustand einnimmt, bleibt der Ausgangsanschluß OUT über den vierten Transistor P4 mit dem zweiten Anschluß 2 verbunden und weist somit ebenfalls einen schwebenden Zustand auf. Dies ist im Zeitabschnitt III der Figur 3 dargestellt. Wenn aber das Eingangssignal IN einen logischen High-Zustand einnimmt, sperrt der fünfte Transistor P5 wieder, während der erste n-Kanal-Transistor N1 durchschaltet und somit an das Gate des sechsten Transistors P6 ein logischer Low-Zustand angelegt wird, wodurch dieser leitend wird und den Ausgangsanschluß OUT zum am ersten Anschluß 1 anliegenden hohen positiven Potential Vpp zieht. Dadurch sperrt der siebte Transistor P7 sicher, so daß der sechste Transistor P6 im leitenden Zustand bleibt. Dieser Fall ist im Zeitabschnitt IV der Figur 3 dargestellt.

Bei Verwendung der in Figur 1 dargestellten erfindungsgemäßen Schaltungsanordnung in einem Flash-Speicher werden jeder Wortleitung eine solche Schaltungsanordnung zugeordnet und über die Wahl des Zustands des Eingangssignals IN kann eine am ersten Anschluß 1 anliegende hohe positive Spannung Vpp oder eine am zweiten Anschluß 2 anliegende hohe negative Spannung -Vpp auf den Ausgangsanschluß OUT der Schaltungsanordnung und somit an die jeweilige Wortleitung des Flash-Speichers die erforderliche Lösch- bzw. Programmierspannung angelegt werden.

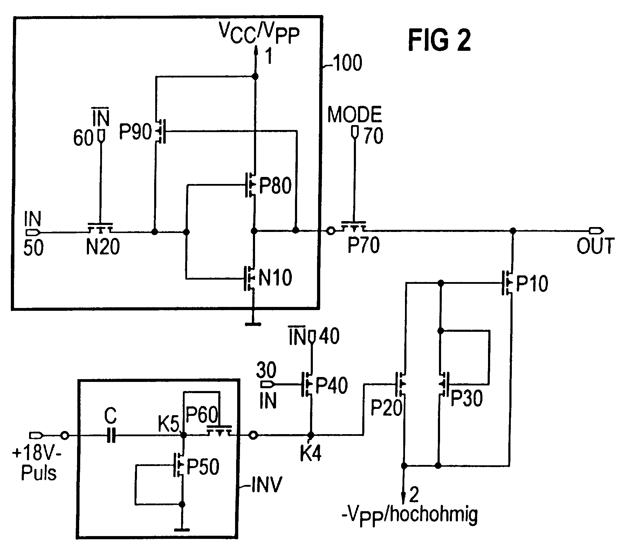

Figur 2 zeigt eine weitere erfindungsgemäße Schaltungsanordnung, mit der entweder eine hohe positive Spannung Vpp oder eine hohe negative Spannung -Vpp an einen Ausgangsanschluß OUT dieser Schaltungsanordnung geschaltet werden kann. Welche der Spannungen durchgeschaltet wird, hängt wiederum davon ab, welchen Zustand ein Eingangssignal IN an Steuereingängen 3 bis 6 für dieses Eingangssignal IN beziehungsweise das invertierte Eingangssignal $\overline{\text{IN}}$ einnimmt, sowie vom Zustand eines Steuersignals MODE, das an einem weiteren Eingangsanschluß 7 anliegt. Auch bei dieser Variante sind alle Transistoren, die in Kontakt mit der hohen negativen Spannung -Vpp kommen können, vom selben Leitungstyp wie das Substrat, im Beispiel der Figur 2, wo ein p-Substrat angenommen ist, sind es also die dort gezeigten p-Kanal-Transistoren. Zwischen den Ausgangsanschluß OUT und den zweiten Anschluß 2 für das hohe negative Potential -Vpp ist die Laststrecke eines ersten Transistors P10 geschaltet. Zwischen dem Gate-Anschluß dieses ersten Transistors P10 und dem zweiten Anschluß 2 ist die Laststrecke eines zweiten Transistors P20 und parallel zu diesem die Laststrecke eines dritten Transistors P30 geschaltet. Der Gate-Anschluß dieses dritten Transistors P30 ist mit dessen Source-Anschluß verbunden, so daß dieser Transistor als Diode geschaltet ist. Wenn nun am Gate-Anschluß des zweiten Transistors P20 eine hohe negative Spannung angelegt wird, so schaltet dieser zweite Transistor P20 durch, wodurch der Gate-Anschluß des ersten Transistors P10 zum am zweiten Anschluß 2 anliegenden, hohen negativen Potential -Vpp gezogen wird. Dadurch schaltet einerseits der erste Transistor P10 durch, wodurch das hohe negative Potential -Vpp zum Ausgangsanschluß OUT durchgeschaltet wird und andererseits beginnt der als Diode geschaltete dritte Transistor P30 zu leiten, wodurch der Gate-Anschluß des ersten Transistors P10 auf dem hohen negativen Potential -Vpp gehalten wird. Dadurch ist es möglich, den Gate-Anschluß des zweiten Transistors P20 nur mit einer pulsförmigen negativen Spannung zu beaufschlagen. Diese wird aus einem hohen positiven Spannungsimpuls von etwa 18V mittels einer Spannungsinvertierschaltung INV erzeugt. Diese Spannungsinvertierschaltung INV ist in herkömmlicher Weise mittels eines Kondensators C, der in Serie mit einem fünften, als in Durchlaßrichtung gepolter Diode geschalteten Transistor P50 und einem sechsten, als in Sperrrichtung gepolter Diode geschalteten Transistor P60, der mit dem Verbindungspunkt des Kondensators C und des fünften Transistors P50 verbunden ist, gebildet. Der nicht mit den Transistoren P50, P60 verbundene Anschluß des Kondensators C bildet den Eingangsanschluß und die Anode der in Sperrrichtung gepolten Diode P60 den Ausgangsanschluß der Spannungsinvertierschaltung INV.

Wenn beispielsweise in einem Flash-Speicher eine von mehreren Wortleitungen mit einer negativen Programmierspannung beaufschlagt werden soll, so kann jede der Wortleitungen mit einem Ausgangsanschluß einer solchen erfindungsgemäßen Schaltungsanordnung verbunden sein. Um eine der Schaltungsanordnungen auszuwählen, kann nun entweder der positive (beispielsweise 18V-)Spannungsimpuls an die auszuwählende Schaltungsanordnung angelegt werden oder aber der Gate-Anschluß des zweiten Transistors P20 über die Laststrecke eines vierten Transistors P40 mit einem Steueranschluß 40, der mit einem invertierten Eingangssignal $\overline{IN}$ beaufschlagt wird, verbunden sein. Der Gate-Anschluß dieses vierten Transistors P40 ist dabei mit einem Eingangsanschluß 30 verbunden, der mit einem nichtinvertierten Eingangssignal IN beaufschlagt wird. Wenn das Eingangssignal IN einen High-Zustand einnimmt, sperrt der vierte Transistor P40, so daß der negative Spannungspuls vom Ausgang der Spannungsinvertierschaltung INV zum Gate-Anschluß des zweiten Transistors P20 durchgeschaltet wird. Wenn jedoch das Eingangssignal IN einen logischen Low-Zustand annimmt, so leitet der vierte Transistor P40, so daß der negative Spannungsimpuls vom Ausgang der Spannungsinvertierschaltung INV zum Eingangsanschluß 40 über den vierten Transistor P40 abgeleitet wird. Durch Wahl des Zustands des Eingangssignals IN an den den verschiedenen Wortleitungen eines Flash-Speichers zugeordneten Schaltungsanordnungen kann somit eine der Schaltungsanordnungen und somit der Wortleitungen ausgewählt werden.

In der Figur 2 ist weiterhin eine Schaltungsanordnung 100 zum Schalten einer hohen positiven Spannung Vpp zum Ausgangsanschluß OUT gezeigt, wie sie beispielsweise aus der Schrift Proceedings ISSCC 1991, Seite 260 bekannt ist. Der Ausgang dieser Schaltung ist über einen siebten Transistor P70 mit dem Ausgangsanschluß OUT verbunden, wobei der Gate-Anschluß dieses siebten Transistors P70 mit einem Eingangsanschluß 70 für ein Steuersignal MODE verbunden ist. Wenn eine hohe negative Spannung -Vpp an den Ausgangsanschluß OUT geschaltet werden soll, so muß am Eingangsanschluß 70 das Steuersignal MODE einen logischen High-Zustand einnehmen, so daß der siebte Transistor P70 sperrt und somit die hohe negative Spannung -Vpp von der Schaltungsanordnung 100 zum Schalten hoher positiver Spannungen isoliert ist, da diese auch n-Kanal-Transistoren aufweist, die nicht in tiefen isolierenden Wannen ausgebildet sein sollen.

Bei der Schaltungsanordnung zum Schalten hoher positiver Spannungen ist zwischen einem ersten Anschluß 1 für positive Spannungen und einem Masse-Anschluß die Serienschaltung aus einem achten Transistor P80 und einem ersten n-Kanal-Transistor N10 geschaltet. Die Gate-Anschlüsse dieser beiden Transistoren sind miteinander und über die Laststrecke eines zweiten n-Kanal-Transistors N20 mit einem Steueranschluß 50, an den ein Eingangssignal IN angelegt werden kann, verbunden. Der Gate-Anschluß dieses zweiten n-Kanal-Transistors N20 ist mit einem Eingangsanschluß 60 verbunden, an den ein invertiertes Eingangssignal IN angelegt werden kann. Der Verbindungspunkt des achten Transistors P80 und des ersten n-Kanal-Transistors N10 bildet den Ausgangsanschluß dieser Schaltungsanordnung 100 zum Schalten hoher positiver Spannungen und ist mit dem Gate-Anschluß eines neunten Transistors P90 verbunden, dessen Laststrecke zwischen dem ersten Anschluß 1 und dem Verbindungspunkt der Gate-Anschlüsse des achten Transistors P80 und des ersten n-Kanal-Transistors N10 angeordnet ist.

**Patentansprüche**

1. MOS-Schaltungsanordnung zum Schalten hoher Spannungen (Vpp, -Vpp) auf einem Halbleiterchip

mit einem ersten Transistor (P1), der in Serie zu einem zweiten Transistor (P2) zwischen einem ersten Anschluß (1) für positive Spannungen und einem zweiten Anschluß (2) für eine hohe negative Spannung angeordnet ist,

mit einem dritten Transistor (P3), der in Serie zu einem vierten Transistor (P4) zwischen dem ersten Anschluß (1) und dem zweiten Anschluß (2) angeordnet ist,

wobei der erste (P1) und der dritte (P3) Transistor direkt mit dem ersten Anschluß (1) verbunden sind,

wobei die Gate-Anschlüsse des zweiten und vierten Transistors (P2, P4) mit dem zweiten Anschluß (2) verbunden sind,

wobei der Gate-Anschluß des ersten Transistors (P1) mit dem einen Ausgangsanschluß (OUT) bildenden Verbindungspunkt des dritten und vierten Transistors (P3, P4) verbunden ist,

wobei der Gate-Anschluß des dritten Transistors (P3) mit dem Verbindungspunkt des ersten und des zweiten Transistors (P1, P2) verbunden ist,

wobei ein fünfter Transistor (P5) mit seiner Laststrecke parallel zur Laststrecke des ersten Transistors (P1) geschaltet ist und der Gate-Anschluß dieses fünften Transistors (P5) einen Steueranschluß (3) für ein Eingangssignal (IN) bildet,

wobei die obengenannten Transistoren (P$_1$-P$_5$) p-leitend und in einer n-Wanne ausgebildet sind und das Substrat p-leitend ist,

wobei die Transistoren (P1 ... P4) derart dimensioniert sind, daß bei Anlegen einer positiven Spannung (Vcc, Vpp) an den ersten Anschluß (1), einer negativen Spannung (-Vpp) an den zweiten Anschluß (2) und einer positiven Spannung an den Steueranschluß (3) zuerst der Verbindungspunkt (K1) zwischen dem ersten (P1) und dem zweiten Transistor (P2) zum zweiten Anschluß gezogen wird.

2. MOS-Schaltungsanordnung nach Anspruch 1, **dadurch gekennzeichnet,**

daß parallel zur Laststrecke des dritten Transistors (P3) die Laststrecke eines sechsten Transistors (P6) geschaltet ist, dessen Gate-Anschluß über die Laststrecke eines achten Transistors (N1) mit einem Anschluß für das invertierte Eingangssignal ($\overline{\text{IN}}$) verbunden ist,

daß der Gate-Anschluß des achten Transistors (N1) mit einem Steueranschluß (4) für das Eingangssignal (IN) verbunden ist,

daß zwischen dem ersten Anschluß und dem Gate-Anschluß des sechsten Transistors (P6) die Laststrecke eines siebten Transistors (P7) gebildet ist, dessen Gate-Anschluß mit dem Ausgangsanschluß (OUT) verbunden ist, und daß der sechste und der siebte Transistor (P6, P7) vom selben Leitungstyp und in einer Wanne und der achte Transistor (N1) vom entgegengesetzten Leitungstyp wie das Substrat ausgebildet ist.

3. MOS-Schaltungsanordnung zum Schalten hoher Spannungen auf einem Halbleiterchip

mit einem ersten Transistor (P10), dessen Laststrecke zwischen einem Ausgangsanschluß (OUT) und einem zweiten Anschluß (2) für eine hohe negative Spannunge (-Vpp) geschaltet ist,

mit einem zweiten Transistor (P20), dessen Laststrecke zwischen dem Gate-Anschluß des ersten Transistors (P10) und dem zweiten Anschluß (2) geschaltet ist,

mit einem dritten Transistor (P30), dessen Laststrecke parallel zur Laststrecke des zweiten Transistors (P20) geschaltet ist und dessen Gate-Anschluß mit dessen Source-Anschluß verbunden ist,

wobei die obengenannten Transistoren (P$_{10}$, P$_{20}$, P$_{30}$) p-leitend und in zumindest einer Wanne ausgebildet sind und das Halbleitersubstrat p-leitend ist und

wobei der Gate-Anschluß des zweiten Transistors (P20) über eine Spannungsinvertierschaltung (INV) mit einem Anschluß für einen hohen positiven Spannungsimpuls verbunden ist.

4. MOS-Schaltungsanordnung nach Anspruch 3, **dadurch gekennzeichnet,**

daß der Gate-Anschluß des zweiten Transistors (P20) über die Laststrecke eines vierten Transistors (P40) mit einem Steueranschluß (40) für ein invertiertes Eingangssignal (IN) verbunden ist,

daß der Gate-Anschluß des vierten Transistors (P4) mit einem Steueranschluß (30) für das Eingangssignal (IN) verbunden ist und

daß der Transistor (P40) vom selben Leitungstyp wie das Halbleitersubstrat und in einer Wanne ausgebildet ist.

5. MOS-Schaltungsanordnung nach einem der Ansprüche 3 oder 4, **dadurch gekennzeichnet,**

daß die Spannungsinvertierschaltung (INV) mit einem Kondensator (C) gebildet ist, dessen erster Anschluß einen Eingangsanschluß der Spannungsinvertierschaltung (INV) und dessen zweiter Anschluß über einen fünften Transistor (P50), der als in Durchlaßrichtung gepolte Diode geschaltet ist, mit einem Masse-Anschluß und über einen sechsten Transistor (P60), der als eine in Sperrichtung gepolte Diode geschaltet ist, mit einem Ausgangsanschluß der Spannungsinvertierschaltung verbunden ist,

und daß die Transistoren vom selben Leitungstyp wie das Halbleitersubstrat und in zumindest einer Wanne ausgebildet sind.

6. MOS-Schaltungsanordnung nach einem der Ansprüche 3 bis 5, **dadurch gekennzeichnet,**
daß der Ausgangsanschluß über einen siebten Transistor (P7) mit einer Schaltungsanordnung (100) zum Schalten hoher positiver Spannungen (Vpp) verbunden ist, wobei der Gate-Anschluß des siebten Transistors (P70) mit einem Steueranschluß (70) für ein Steuersignal (MODE) verbunden ist.

**Claims**

1. MOS circuit arrangement for switching high voltages (Vpp, -Vpp) on a semiconductor chip with a first transistor (P1) which is arranged in series with a second transistor (P2) between a first terminal (1) for positive voltages and a second terminal (2) for a high negative voltage, with a third transistor (P3) which is arranged in series with a fourth transistor (P4) between the first terminal (1) and the second terminal (2), the first transistor (P1) and the third transistor (P3) being directly connected to the first terminal (1), the gate terminals of the second and fourth transistors (P2, P4) being connected to the second terminal (2), the gate terminal of the first transistor (P1) being connected to the connection point, forming an output terminal (OUT), of the third and fourth transistors (P3, P4), the gate terminal of the third transistor (P3) being connected to the connection point of the first and second transistors (P1, P2), a fifth transistor (P5) being connected with its load path parallel to the load path of the first transistor (P1) and the gate terminal of this fifth transistor (P5) forming a control terminal (3) for an input signal (IN), the abovementioned transistors ($P_1$-$P_5$) being p-conductive and being constructed in an n-well, and the substrate being p-conductive, the transistors (P1 ... P4) being dimensioned in such a way that when a positive voltage (Vcc, Vpp) is applied to the first terminal (1), a negative voltage (-Vpp) is applied to the second terminal (2) and a positive voltage is applied to the control terminal (3), the connection point (K1) between the first transistor (P1) and the second transistor (P2) is first of all drawn to the terminal.

2. MOS circuit arrangement according to Claim 1, characterized in that the load path of a sixth transistor (P6) is connected parallel to the load path of the third transistor (P3), the gate terminal of the said sixth transistor (P6) being connected via the load path of an eighth transistor (N1) to a terminal for the inverting input signal (IN), in that the gate terminal of the eighth transistor (N1) is connected to a control terminal (4) for the input signal (IN), in that the load path of a seventh transistor (P7) is formed between the first terminal and the gate terminal of the sixth transistor (P6), the gate terminal of the said seventh transistor (P7) being connected to the output terminal (OUT), and in that the sixth and seventh transistors (P6, P7) are of the same conduction type and are constructed in a well and the eighth transistor (N1) is of the opposite conduction type to the substrate.

3. MOS circuit arrangement for switching high voltages on a semiconductor chip, with a first transistor (P10) whose load path is connected between an output terminal (OUT) and a second terminal (2) for a high negative voltage (-Vpp), with a second transistor (P20) whose load path is connected between the gate terminal of the first transistor (P10) and the second terminal (2), with a third transistor (P30) whose load path is connected parallel to the load path of the second transistor (P20) and whose gate terminal is connected to its source terminal, the abovementioned transistors ($P_{10}$, $P_{20}$, $P_{30}$) being p-conductive and being constructed in at least one well, and the semiconductor substrate being p-conductive, and the gate terminal of the second transistor (P20) being connected via a voltage-inverting circuit (INV) to a terminal for a high positive voltage pulse.

4. MOS circuit arrangement according to Claim 3, characterized in that the gate terminal of the second transistor (P20) is connected via the load path of a fourth transistor (P40) to a control terminal (40) for an inverted input signal ($\overline{\text{IN}}$), in that the gate terminal of the fourth transistor (P4) is connected to a control terminal (30) for the input signal (IN), and in that the transistor (P40) is of the same conduction type as the semiconductor substrate and is constructed in a well.

5. MOS circuit arrangement according to one of Claims 3 or 4, characterized in that the voltage-inverting circuit (INV) is formed with a capacitor (C) whose first terminal is connected to an input terminal of the voltage-inverting circuit (INV) and whose second terminal is connected via a fifth transistor (P50), which is connected as a diode with its polarity in the conducting direction, to an earth terminal and via a sixth transistor (P60), which is connected as a diode with its polarity in the blocking direction, to an output terminal of the voltage-inverting circuit, and in that the transistors are of the same conduction type as the semiconductor substrate and are constructed in at least one well.

6. MOS circuit arrangement according to one of Claims 3 to 5, characterized in that the output terminal is connected via a seventh transistor (P7) to a circuit arrangement (100) for switching high positive voltages (Vpp), the gate terminal of the seventh transistor (P70) being connected to a control terminal (70) for a control signal (MODE).

**Revendications**

1. Montage MOS pour la commutation de tensions élevées (Vpp, -Vpp) sur une puce de semi-conducteur,

comprenant un premier transistor (P1) qui est monté en série avec un second transistor (P2), entre une première borne (1) pour des tensions positives et une seconde borne (2) pour une tension négative élevée,
comprenant un troisième transistor (P3) qui est monté en série avec un quatrième transistor (P4), entre la première borne (1) et la seconde borne (2),
le premier transistor (P1) et le troisième transistor (P3) étant reliés directement à la première borne (1), les bornes de grille du second et du quatrième transistors (P2, P4) étant reliées à la seconde borne (2),
la borne de grille du premier transistor (P1) étant reliée au point de liaison du troisième et du quatrième transistor (P3, P4), qui forme une borne de sortie (OUT),
la borne de grille du troisième transistor (P3) étant reliée au point de liaison du premier et du second transistor (P1, P2),
un cinquième transistor (P5) étant monté, par sa branche de charge, en parallèle à la branche de charge du premier transistor (P1), et la borne de grille de ce cinquième transistor (P5) formant une borne de commande (3) pour un signal d'entrée (IN),
les transistors (P1 à P5) précités étant de conductivité p et réalisés dans un puits du type n, et le substrat étant de conductivité p,
les transistors (P1 ... P4) étant dimensionnés de manière telle, que lorsque l'on applique une tension positive (Vcc, Vpp) à la première borne (1), une tension négative (-Vpp) à la seconde borne (2) et une tension positive à la borne de commande (3), le point de liaison (K1) entre le premier (P1) et le second transistor (P2) soit tout d'abord tiré vers la seconde borne.

2. Montage MOS selon la revendication 1, **caractérisé**

en ce qu'en parallèle à la branche de charge du troisième transistor (P3) est montée la branche de charge d'un sixième transistor (P6) dont la borne de grille est reliée par l'intermédiaire de la branche de charge d'un huitième transistor (N1), à une borne pour le signal d'entrée inverse (IN),
en ce que la borne de grille du huitième transistor (N1) est reliée à une borne de commande (4) pour le signal d'entrée (IN),
en ce qu'entre la première borne et la borne de grille du sixième transistor (P6) est formée la branche de charge d'un septième transistor (P7), dont la borne de grille est reliée à la borne de sortie (OUT), et en ce que le sixième et le septième transistor (P6, P7) sont du même type de conductivité que le substrat et sont réalisés dans un puits, et le huitième transistor (N1) est d'un type de conductivité opposé à celui du substrat.

3. Montage MOS pour la commutation de tensions élevées sur une puce de semi-conducteur,

comprenant un premier transistor (P10) dont la branche de charge est montée entre une borne de sortie (OUT) et une seconde borne (2) pour une tension négative (-Vpp) élevée,
comprenant un second transistor (P20) dont la branche de charge est montée entre la borne de grille du premier transistor (P10) et la seconde borne (2),
comprenant un troisième transistor (P30) dont la branche de charge est montée en parallèle à la branche de charge du second transistor (P20) et dont la borne de grille est reliée à sa borne de source,
les transistors (P10, P20, P30) précités étant de conductivité p et réalisés dans au moins un puits, et le substrat semi-conducteur étant de conductivité p, et la borne de grille du second transistor (P20) étant reliée, par l'intermédiaire d'un circuit d'inversion Ce tension (INV), à une borne pour une impulsion de tension positive élevée.

4. Montage MOS selon la revendication 3, **caractérisé**

en ce que la borne de grille du second transistor (P20) est reliée, par l'intermédiaire de la branche de charge d'un quatrième transistor (P40), à une borne de commande (40) pour un signal d'entrée inverse (IN),
en ce que la borne de grille du quatrième transistor (P40) est reliée à une borne de commande (30) pour le signal d'entrée (IN), et
en ce que le transistor (P40) est du même type de conductivité que le substrat semi-conducteur et est réalisé dans un puits.

**5.** Montage MOS selon l'une des revendications 3 ou 4, **caractérisé**

en ce que le circuit d'inversion de tension (INV) est formé à l'aide d'un condensateur (C) dont la première borne est reliée à une borne d'entrée du circuit d'inversion de tension (INV), et dont la seconde borne est reliée, par l'intermédiaire d'un cinquième transistor (P50) monté en tant que diode polarisée dans le sens direct, à une borne à la masse, et par l'intermédiaire d'un sixième transistor (P60) monté en tant que diode polarisée dans le sens inverse, à une borne de sortie du circuit d'inversion de tension, et en ce que les transistors sont du même type de conductivité que le substrat et sont réalisés dans au moins un puits.

**6.** Montage MOS selon l'une des revendications 3 à 5, **caractérisé**
en ce que la borne de sortie est reliée, par l'intermédiaire d'un septième transistor (P70), à un montage (100) destiné à commuter des tensions positives (Vpp) élevées, la borne de grille du septième transistor (P70) étant reliée à une borne de commande (70) pour un signal de commande (MODE).

FIG 1

$V_{CC}/V_{PP}$

1

IN 3 P5

P1 P3

K1

P2 P4

2

-$V_{PP}$/hochohmig

P6

P7

N1 K2

IN 4

$\overline{IN}$ 5

OUT

FIG 3 1

I    II    III    IV

+$V_{PP}$
$V_{CC}$

2

-$V_{PP}$

IN $V_{CC}$

+$V_{PP}$

OUT $V_{CC}$

-$V_{PP}$

# FIG 2